# EUROPEAN PATENT APPLICATION

(11) **EP 4 844 804 A1**
(43) Date of publication of application: **25.11.2026**
(21) Application number: 25178416.1
(22) Date of filing: 23.05.2025
(51) Int. Cl.: H01J 37/20, H01J 37/305

(54) **SAMPLE HOLDER AND ION MILL**

(71) Applicant: Leica Mikrosysteme GmbH, 1170 Wien (AT)
(72) Inventor: WELLER, Miriam, 1170 Wien (AT); PLANK, Heinz, 1170 Wien (AT); WURZINGER, Paul, 1170 Wien (AT); ERDEN, Lejs, 1170 Wien (AT)
(74) Representative: 2SPL Patentanwälte PartG mbB

(57) **Abstract**

A sample holder for holding a sample during etching with an ion mill comprises a sample carrier structure comprising a carrier surface for the placement of a sample. Further, the sample holder comprises an etching mask configured to shield a portion of the sample with respect to an ion beam of an ion mill during etching and a deformable element structure configured to press the sample directly or indirectly towards the carrier surface at an edge of the etching mask during etching. The deformable element structure is a deformable element or comprises a deformable element.

## Description

### Field

The present disclosure relates to sample holders for etching with an ion mill.

### Background

Ion milling relates to a material processing technique that uses a focused beam of ions to remove surface layers from a sample through sputtering. It may be employed in the preparation of cross-sections for microscopic analysis, e.g., in materials science, semiconductor research, failure analysis, or the like. Precise control over the etching process may be needed to reveal internal structures without introducing artifacts or damage. Effectiveness of ion milling may depend on factors such as ion energy, beam angle, sample composition, and the like.

For example, slope etching may be used as an etching technique. In slope etching, an ion beam may be directed at a shallow angle relative to the sample surface to create a gradually inclined cross-section. This method may enhance the visibility of layered structures and enables high-resolution analysis across extended depths of the sample.

There may be a demand to provide improved techniques for etching.

### Summary

This demand may be satisfied by the subject-matter of the independent claims. Further aspects are set forth in the dependent claims, the drawings, and the following description.

Some examples relate to a sample holder for holding a sample during etching with an ion mill, the sample holder comprising a sample carrier structure comprising a carrier surface for the placement of a sample. Further, the sample holder comprises an etching mask configured to shield a portion of the sample with respect to an ion beam of an ion mill during etching and a deformable element structure configured to press the sample directly or indirectly towards the carrier surface at an edge of the etching mask during etching. The deformable element structure is a deformable element or comprises a deformable element.

By pressing the sample towards the carrier surface at an edge of the etching mask by the etching mask or the deformable element, a gap between the sample and the edge of the etching mask can be reduced or avoided. By avoiding or reducing a gap between the sample and the edge of the etching mask a redeposition of etched material on the sample surface can be reduced or avoided.

The deformable element may be arranged in the force flow between the etching mask and the sample carrier structure.

The deformable element structure may comprise the deformable element and an etch mask carrier structure. The deformable element may be arranged between the etching mask and the etch mask carrier structure. The deformable element may be deformable to enable a movement of the etching mask relative to the etch mask carrier structure.

The deformable element may be a tension spring configured to pull the etching mask towards the carrier surface of the sample carrier structure.

The deformable element may be a compression spring configured to push a mask carrier structure of the deformable element structure towards a screw head of a screw of the deformable element structure. The etching mask may be connected to the mask carrier structure. The screw may be configured to adjust a distance between the etching mask and the carrier surface of the sample carrier structure.

The sample holder may be configured to change an orientation of the edge of the etching mask due to an elastic deformation of the deformable element.

The deformable element may be attached to the edge of the etching mask.

The deformable element may be configured to fill a gap between the etching mask and the sample.

The deformable element may be configured to adapt to a surface contour of the sample by plastic or elastic deformation of the deformable element.

The etching mask may comprise a bottom surface extending from the edge of the etching mask and facing the carrier surface of the sample carrier structure. The bottom surface of the etching mask and the carrier surface of the sample carrier structure may be non-parallel.

The edge of the etching mask may be in parallel to the carrier surface of the sample carrier structure, if no sample is placed in the sample holder.

The deformable element may be a spring or comprises at least one of silicone, a wax, a Wood's metal, a resin, or a cellulose acetate.

The etching mask may comprise or may be made of at least one of chromium or nickel.

Some examples relate to an ion mill comprising a sample holder as described above or below.

According to an aspect, the disclosure provides a device for shielding a sample for slope etching with an ion mill. The device includes an etching mask configured to shield a portion of the sample with respect to an ion beam such that, during the etching process with the ion beam, only an unshielded portion of the sample is etched. The device further includes a deformable element connectable to the etching mask and the sample. The deformable element is configured to, when deformed, further shield the portion of the sample from the ion beam.

Thereby, shielding of the sample may be improved.

In some examples, the deformable element is configured to shield the portion of the sample from the ion beam by decreasing a distance between the etching mask and the sample.

Thereby, ion leakage onto unwanted regions may be reduced.

In some examples, the deformable element is configured to shield the portion of the sample from the ion beam by filling at least one gap between the etching mask and the sample.

Thereby, shielding of samples with uneven surfaces may be improved.

In some examples, the deformable element is plastically deformable to adapt to a surface contour of the sample.

Thereby, no additional elements may be needed for shielding.

In some examples, the deformable element is based on at least one of a wax, a Wood's metal, a resin, and a cellulose acetate.

Thereby, plastic deformation may be achieved.

In some examples, the deformable element is elastically deformable to adapt to a surface contour of the sample.

Thereby, the deformable element may be reused.

In some examples, the deformable element is based on silicone.

Thereby, elastic or viscoelastic deformation may be achieved.

In some examples, the deformable element is based on a material that is formulated to remain stable under vacuum conditions and which has, under the vacuum conditions, a vapor pressure below a predetermined threshold.

Thereby, vacuum conditions may be maintained stable without outgassing of the deformable element.

In some examples, the deformable element is provided at an edge of the etching mask to be in direct contact with the sample.

Thereby, gaps may be filled and shielding may be improved.

In some examples, the device further includes a sample holder. The device is configured to clamp the sample between the sample holder and the etching mask.

Thereby, shielding of tilted samples surfaces may be improved.

In some examples, the sample holder includes a first part configured to be in contact with the sample, and a second part configured for attachment of the etching mask. In such examples, wherein the deformable element is provided between the first part and the second part of the sample holder.

Thereby, clamping of the sample may be provided.

In some examples, the deformable element is configured to, when deformed, generate a clamping force for clamping the sample between the first part and the second part.

Thereby, clamping of the sample may be further provided.

In some examples, the deformable element includes at least one spring. The clamping force corresponds to a spring force that the at least one spring exerts when a distance between the first part and the second part is increased.

Thereby, clamping of the sample may be further provided.

In some examples, the device further includes a fixing member configured to fix a position of the deformable element when the etching mask is aligned with the sample.

Thereby, the sample may be further tightened between the sample holder and the mask to further shield the sample.

According to a second aspect, the disclosure provides an ion mill including a device according to the first aspect or according to any example relating to the first aspect.

### Brief description of the Figures

Some examples of apparatuses and/or methods will be described in the following by way of example only, and with reference to the accompanying figures, in which
Fig. 1 depicts an ion mill according to the present disclosure;
Fig. 2a and 2b depicts various samples with different geometries;
Fig. 3a depicts a schematic illustration of a part of a sample holder and a sample;
Fig. 3b depicts a schematic illustration of a part of a sample holder and a sample; and
Fig. 4 depicts a schematic illustration of a sample holder; and
Fig. 5 depicts a schematic illustration of a sample holder.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

The present disclosure relates to ion milling, in particular to slope etching of samples (or specimen). In this context, an ion mill may relate to a device or system configured to perform material removal of the sample using a focused or broad beam of ions under vacuum- or near-vacuum conditions, e.g., for the purpose of thinning, polishing, or structuring surfaces of the sample at micro- or nanoscale resolution.

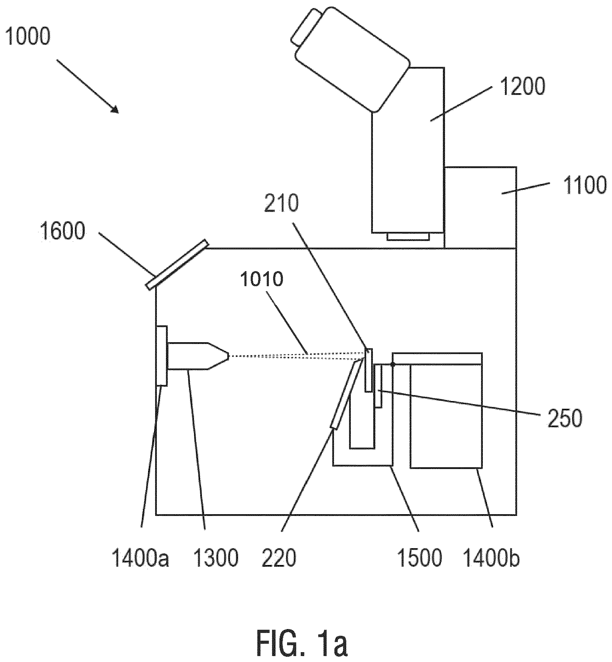

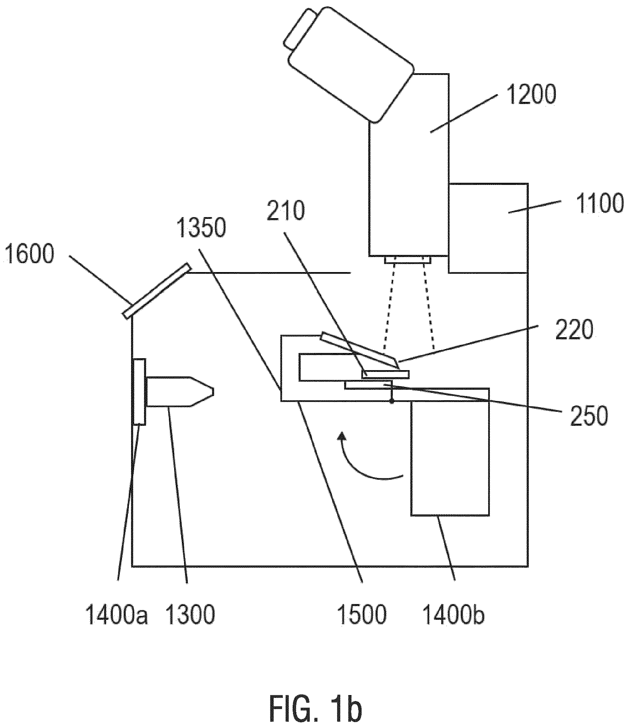

An schematic view of an ion mill 1000 is shown in Figs. 1a and 1b and discussed in the following.

Generally, ion mills, such as the ion mill 1000, may operate by directing a beam 1010 of inert gas ions (such as argon ions) toward a target surface of the sample 210, where the kinetic energy of the ions may cause atoms to be sputtered away. Ion milling may be used in the context of applications requiring precise and controlled material removal without inducing mechanical stress or significant thermal effects. For example, ion mills may be employed in the preparation of transmission electron microscopy (TEM) specimens, where extremely thin samples (e.g., thinner than 100 nanometers (nm), such as in the range of 20 to 80 nm) may be needed for electron transparency. For example, in TEM, ion milling may be used for removing surface damage layers introduced during mechanical polishing or other preparatory steps. Furthermore, ion mills may be used in failure analysis, cross-sectioning of multilayer semiconductor devices, in nanostructure fabrication, semiconductor device fabrication, materials science research, high-resolution microscopy workflows that demand atomically flat or extremely thin samples, or the like.

The ion milling system 1000 may include several components. These include at least one ion emitter 1300, which comprises the ion source that generates the ion beam 1010 and ion optics, which are used to direct the beam 1010 onto the sample 210. A mechanical ion beam positioning system 1400a is used to target the sample by adjusting at least one of a lateral position, vertical position, or orientation of the at least one ion emitter 1300.

A sample stage 1500 holds and positions the sample during processing. The sample 210 is attached to a sample holder, which is mounted to the sample stage 1500. An etching mask 220 partially shields the sample 210 during ion milling. The term etching mask 220 may relate to a physical barrier that is positioned adjacent to the sample 210 to block selected regions from exposure to the ion beam 1010. During ion milling, the etching mask 220 may ensure that only unshielded portions of the sample 210 are etched, thereby enabling patterning or localized material removal. The etching mask 220 may be shaped or aligned to define the desired slope geometry and protect sensitive areas from unwanted modification.

A mechanical sample stage positioning system 1400b is used to position the sample stage 1500 with the sample 210 relative to the ion beam 1010, with the mechanical sample stage positioning system 1400b being configured to adjust at least one of a lateral position, vertical position, or orientation of the sample stage 1500, and therefore of the sample 210. The ion milling system 1000 may also use vacuum equipment to maintain vacuum conditions. A control system 1100 controls the operation and parameters of the ion milling process, allowing for adjustments to be made for different applications and material types. The control system 1100 can be controlled via a touch-screen display 1600, which is coupled to the control system 1100.

In the ion milling system 1000 shown in Figs. 1a and 1b, a digital or hybrid microscope 1200 allows a user to inspect the sample 210 that is placed on the sample stage 1500. The control system 1100 uses image data from the microscope 1200, which performs the function of an imaging device. Alternatively, a camera may be placed in the chamber of the ion milling system 1000 and be used to monitor the sample 210 before and after the ion milling. As the sputtering leads to deposition of material removed from the sample on the components inside the ion milling chamber, the camera may be shielded from the sample chamber during ion milling, e.g., using a retractable shield, which may be removed periodically or occasionally to allow for monitoring of the progress of the ion milling process.

Slope etching may refer to the process of removing material from the sample 210 at a shallow angle relative to the sample's 210 surface, thereby creating an oblique cross-section. This technique enables the gradual exposure of underlying structures within the sample, which can be beneficial for detailed analysis using microscopy. In the context of ion milling, slope etching facilitates high-resolution imaging of layered or composite materials by enhancing depth contrast and minimizing curtaining effects.

In this context, the sample 210 may relate to a physical specimen intended for the above-described material removal or slope etching. For example, the sample 210 may be based on at least one of the following materials that are suitable for ion milling: silicon, glass, ceramics, metals, composite materials used in semiconductor, geological, or materials science applications, or the like.

In slope etching, only the part of the sample should be etched that is not shielded by the mask. For this purpose, the mask should be as close to the sample as possible to prevent ion leakage and to prevent re-deposition of sputtered material in gaps or unwanted areas of the sample.

For example, between a surface of the sample 210 and the mask 220, gaps or uneven areas might be present. In other words, the surface contour of the sample might not fit to the surface contour of the mask.

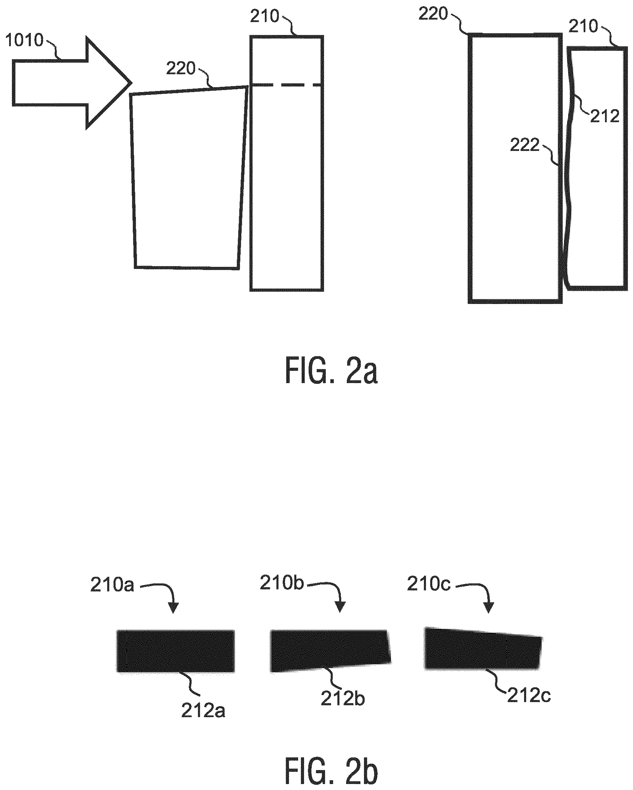

An exemplary situation of such a case is depicted in Fig. 2a which depicts the sample 210 and the mask 220 in a top view. The sample 210 has an uneven contact surface 212 that is not fully in contact with the intended contact surface 222 of the mask 220. Thus, gaps are present between the sample 210 and the mask 220. In such a case, ions can pass the gaps and collide with parts of the sample 210 which are not intended for slope etching and thus, deteriorate quality of the sample 210, and/or etched material may be redeposited on the sample surface.

Another exemplary scenario is depicted in Fig. 2b. Although samples 210a, 210b, and 210c (depicted in a top view) might have straight contact surfaces 212a, 212b, and 212c for slope etching, they might not necessarily fit to the mask 220, because they are tilted, as can be seen for samples 210b and 210c. Thus, the mask might not fully shield the whole contact area 212b or 212c and ions can sputter away parts of the samples 210b and 210c that are not intended for slope etching and/or etched material may be redeposited on the sample surface.

To overcome such scenarios, a device for shielding a sample for slope etching with an ion mill is proposed. Shielding may relate to the process of selectively blocking a portion of a sample 210 from exposure to the ion beam 1010 during etching. This may be necessary to preserve specific regions of the sample 210 from material removal, thereby enabling controlled shaping or the creation of defined etching profiles.

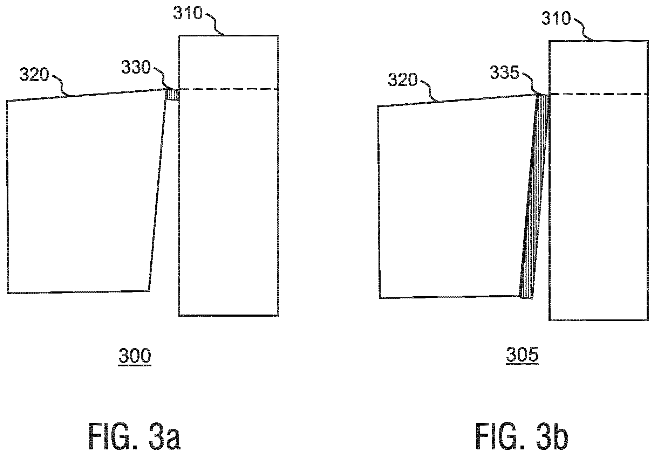

A proposed sample holder may be implemented in various ways (e.g. Fig. 3a-5). For example, a sample holder 300, 305, 400, 500 for holding a sample 310, 410, 510 during etching with an ion mill 1000 comprises a sample carrier structure 450 comprising a carrier surface for the placement of a sample 310, 410, 510. Further, the sample holder comprises an etching mask 320, 420, 522 configured to shield a portion of the sample 310, 410, 510 with respect to an ion beam of an ion mill 1000 during etching. Further, the sample holder comprises a deformable element structure configured to press the sample 310, 410, 510 directly or indirectly towards the carrier surface at an edge of the etching mask during etching. The deformable element structure is a deformable element 330, 335, 430, 530 or comprises a deformable element 330, 335, 430, 530.

By pressing the sample towards the carrier surface at an edge of the etching mask by the etching mask or the deformable element, a gap between the sample and the edge of the etching mask can be reduced or avoided. By avoiding or reducing a gap between the sample and the edge of the etching mask a redeposition of etched material on the sample surface can be reduced or avoided.

For example, if a sample is placed on the carrier surface, the sample is directly or indirectly clamped or fixed between the sample carrier structure 450 and the etching mask 320, 420, 522. The sample 310, 410, 510 may be pressed towards the carrier surface directly by the edge of the etching mask 320, 420, 522 or by the deformable element 330, 335, 430, 530 attached to the edge of the etching mask 320, 420, 522.

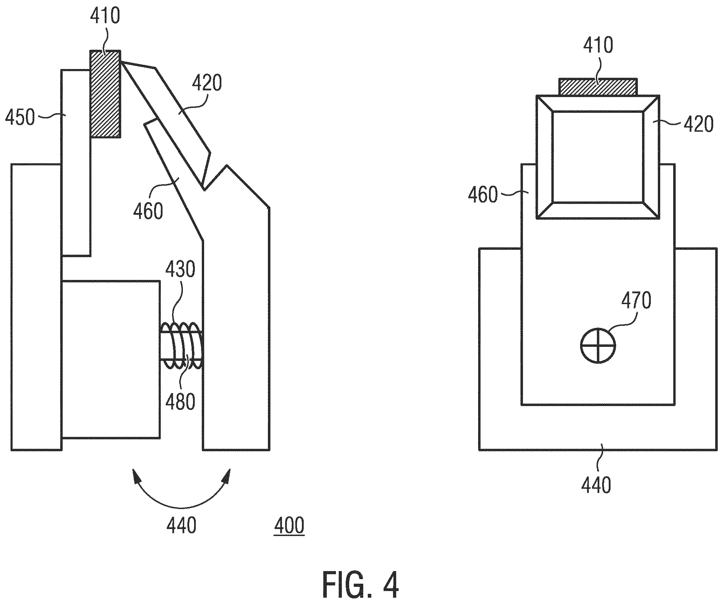

The deformable element 430, 530 may be arranged in the force flow between the etching mask 420, 522 and the sample carrier structure 450 (e.g. Fig. 4 or 5). The flow of force between the etching mask 420, 522 and the sample carrier structure 450 may pass through all elements of the sample holder that contribute to the clamping force used to hold the sample during etching.

For example, the deformable element structure may comprise the deformable element 530 and an etch mask carrier structure 524 (e.g. Fig 5). The deformable element 530 may be arranged between the etching mask 522 and the etch mask carrier structure 524. The deformable element 530 may be deformable to enable a movement (e.g tilting) of the etching mask 522 relative to the etch mask carrier structure 524.

For example, the deformable element 430 may be a spring (e.g. Fig. 4). For example, the deformable element 430 may be a tension spring configured to pull the etching mask 420 towards the carrier surface of the sample carrier structure 450. Alternatively, the deformable element 430 may be a compression spring configured to push a mask carrier structure 460 of the deformable element structure towards a screw head of a screw 470 of the deformable element structure. The etching mask 420 may be connected to the mask carrier structure 460. The screw 470 may be configured to adjust a distance between the etching mask 420 and the carrier surface of the sample carrier structure 450. In this way, the force applied to the sample 410 by the edge of the etching mask 420 may be better controlled during tightening the screw 470. The etching mask 420 may be rotatably or tiltable mounted so that the edge of the etching mask 420 can slightly change the orientation of the edge of the etching mask 420 to adapt to the sample surface. The sample holder may be configured to change an orientation or alignment of the edge of the etching mask due to an elastic deformation of the deformable element 430.

In some examples, the deformable element 330, 335 may be attached to the edge of the etching mask 320 (e.g. Fig. 3a or 3b). The deformable element 330, 335 may be configured to fill a gap between the etching mask 320 and the sample 310. The deformable element 330, 335 may be configured to adapt to a surface contour of the sample 310 by plastic or elastic deformation of the deformable element 330, 335. By attaching the deformable element 330, 335 at the edge of the etching mask 320, a gap between the sample 310 and the etching mask 320 may be completely or almost completely closed. The deformable element 330, 335 may be attached only to the edge of the etching mask 320 (e.g. Fig. 3a), attached to the complete bottom surface of the etching mask 320 (e.g. Fig. 3b) or attached to a part of the bottom surface of the etching mask 320, which includes the edge of the etching mask 320.

The deformable element 330, 335, 430, 530 may be a spring or may comprise at least one of silicone, a wax, a Wood's metal, a resin, or a cellulose acetate or another material described in connection with Fig. 3a and 3b.

For example, the etching mask 320, 420, 522 partially shields the sample 310, 410, 510 during ion milling. The etching mask 320, 420, 522 may be a physical barrier that is positioned adjacent to the sample 310, 410, 510 to block selected regions from exposure to the ion beam. The edge of the etching mask 320, 420, 522 may be the part of the etching mask 320, 420, 522 closest to the sample during etching and/or may be the part of the etching mask 320, 420, 522, which defines the border between a shielded portion and an unshielded portion of the sample 310, 410, 510. The etching mask 320, 420, 522 may comprise (e.g. as a surface coating) or may be made of a material that has a high resilience against etching or milling by the ion beam. For example, the 20, 420, 522 may comprise (e.g. as a surface coating) or may be made of at least one of chromium or nickel.

The edge of the etching mask 320, 420, 522 may be in parallel to the carrier surface of the sample carrier structure, if no sample is placed in the sample holder, or the edge of the etching mask 320, 420, 522 may be always in parallel to the carrier surface of the sample carrier structure. The etching mask 320, 420, 522 may be integrated in the sample holder so that the edge of the etching mask 320, 420, 522 can slightly change (e.g. by tilting or rotating) the orientation or alignment of the edge of the etching mask 320, 420, 522 to adapt to the sample surface. For example, the etching mask 320, 420, 522 may be configured to change the orientation or alignment of the edge of the etching mask 320, 420, 522 by at most 5° (or at most 10° or at most 3°).

The etching mask 320, 420, 522 may comprise a bottom surface extending from the edge of the etching mask 320, 420, 522 and facing the carrier surface of the sample carrier structure 450. The bottom surface of the etching mask 320, 420, 522 and the carrier surface of the sample carrier structure 450 may be non-parallel. In this way, it may be ensured that the edge of the etching mask 320, 420, 522 is in contact or closest to the sample 310, 410, 510 and not another part of the etching mask 320, 420, 522.

The sample carrier structure 450 may have any geometry and/or may be made of any material providing a carrier surface (e.g. flat surface) for placing a sample. The sample carrier structure 450 may have holding elements or edges for holding the sample in a desired lateral position on the carrier surface.

The sample holder may be used for etching in an ion mill 1000 as described in connection with Fig. 1a and/or 1b.

More details and aspects are mentioned in connection with the examples described above or below. The previously described example may comprise one or more optional additional features corresponding to one or more aspects mentioned in connection with the proposed concept or one or more examples described above (e.g. Fig. 1a-1b) or below (e.g. Fig. 3a-5).

For example, the device (e.g. sample holder) of the present disclosure includes an etching mask configured to shield a portion of the sample with respect to an ion beam such that, during the etching process with the ion beam, only an unshielded portion of the sample is etched. The device of further includes a deformable element connectable (or connected) to the etching mask and the sample. The deformable element may be configured to, when deformed, further shield the portion of the sample from the ion beam.

The deformable element may relate to a structural or material component that is capable of changing its shape or configuration in response to mechanical interaction. The deformable element may be used to conform to irregularities between the etching mask and the sample surface, thereby enhancing the sealing effect and reducing ion beam leakage. The deformable element may exhibit at least one of plastic and elastic behavior depending on its material properties and intended function. For instance, it may permanently adapt its shape to the surface contours of a sample, or it may temporarily compress or flex to accommodate for surface mismatches. The use of a deformable element may allow for more precise control over the exposed and shielded areas of the sample, thus achieving reproducible and localized slope etching results.

The deformable element may further shield the portion of the sample of the ion beam, i.e., contributes to the overall shielding. In other words, shielding may be provided by the mask in conjunction with the deformable element and the deformable element may contribute to the shielding, e.g., by closing at least one gap between the etching mask and the sample, or by exerting a force to bring the mask closer to the sample (i.e., by clamping the sample to the etching mask). The deformable element may be configured to shield the portion of the sample from the ion beam by decreasing a distance between the etching mask and the sample.

The device may be used in the ion mill 1000 of Fig. 1 or in any other configuration of ion mills during slope etching.

Fig. 3a depicts a schematic illustration of a sample holder 300 according to the present disclosure for shielding a sample 310. The device includes a mask 320 and a deformable element 330. When the sample 310 is aligned with the mask 320, at least one gap may be present between the sample 310 and the mask 320 due to a surface contour of at least one of the mask 320 and the sample 310, as discussed under reference of Fig. 2a. The deformable element 310 may be configured to further shield the portion of the sample 310 that should not be etched from the ion beam by filling the at least one gap between the etching mask 320 and the sample 310. To do so, the deformable element 330 may be provided at an edge of the etching mask 320 to be in direct contact with the sample 310, as depicted in Fig. 3a. The example of Fig. 3b differs from the example of Fig. 3a by the extension of the deformable element 335. The deformable element 335 of Fig. 3b is attached to the complete bottom surface of the etching mask 320.

The deformable element 330 may be plastically deformable to adapt to the surface contour of at least one of the sample 310 and the etching mask 320. Plastic deformation may refer to a permanent change in the shape of a material when subjected to mechanical stress beyond its elastic limit. In the context of the deformable element 330, plastic deformation may enable the deformable element 330 to conform to surface contours and retain its adapted shape without rebounding.

For example, when the sample is prepared by a user, the deformable element 330 may be pressed against the sample 310 or sandwiched between the sample 310 and the mask 320. The pressing or sandwiching may then cause the deformable element 330 to deform and adapt to the surface contour such that the at least one gap is closed. Alternatively, this process may at least partially be automated by a device (e.g., a press) configured to prepare the sample as described above. To achieve the plastic deformable properties, the deformable element 330 may be based on at least one of a wax, a Wood's metal, a resin, a cellulose acetate, or the like.

In some examples, adaptation to the sample surface may be achieved by heating the deformable element 330 (e.g., Wood's metal, seal wax, or the like). In some examples, a solvent may be used to soften the material (thus providing the deformable element 330) to adapt to the sample surface (e.g., cellulose acetate foil, or the like). The solvent may then evaporate to harden the material again.

In another example, the deformable element 330 is elastically deformable to adapt to the surface contour of the sample 310. Elastic deformation may refer to a reversible change in the shape of a material under applied stress, where the material returns to its original form once the stress is removed. For the deformable element 330, elastic deformation may allow temporary adaptation to surface irregularities or the application of clamping forces while maintaining structural integrity.

In such an example, force or pressure needed to deform the deformable element 330 to close the at least one gap may be upheld during ion milling (e.g., using a clamping mechanism to sandwich the deformable element 330 between the mask 320 and the sample 310). However, in such an example, it may be easier to reuse the deformable element 330 for the next sample, or it may be reused more often than a plastically deformable element 330. To achieve the elastic deformable properties of the deformable element 330, it may be based on silicone, or the like.

On the other hand, a material may be used for the deformable element 330 that has both plastic and elastic deformation properties, or viscoelastic properties, such as a gel (e.g., a hydrogel or an organogel). Such materials may behave primarily as soft elastic materials under small deformations, i.e., they may return to their original shape when the load is removed. However, under larger or sustained stresses, many gels may undergo plastic-like deformation, where the internal polymer network breaks or rearranges, leading to a permanent shape change. Some gels may also display time-dependent (viscoelastic) responses, meaning their deformation and recovery are not instantaneous but occur over a time scale.

For example, a viscoelastic material (such as epoxy resin) may be primarily soft, but after contact with the sample surface, it may be hardened (e.g., based on radiation with blue light, timely polymerization, or the like).

The specific behavior under mechanical stress of gels may depend on factors like crosslink density, solvent content, temperature, strain rate, and the like. For example, silicone-based gels may show both good elasticity and some plasticity when sufficiently stressed, making them useful as conformal, semi-permanent fillers or seals in vacuum and microfabrication contexts, such as ion milling in the context of the present disclosure.

Since ion milling may happen in vacuum, in some examples, the deformable element 330 is based on a material that is formulated to remain stable under vacuum conditions and which has (under the vacuum conditions) a vapor pressure below a predetermined threshold.

Vacuum conditions may relate to a pressure state below atmospheric pressure, e.g., established and maintained within enclosed regions of the ion mill 1000 to enable ion beam processing without interference from ambient gas particles. In the context of the present disclosure, vacuum conditions may refer to low-pressure environments that support the generation, propagation, and focusing of ion beams, such as the ion beam 1010, without significant scattering, attenuation, or contamination. Vacuum levels may vary depending on the specific operational requirements of the ion mill 1010, and may include high vacuum (e.g., in the range of 10⁻³ to 10⁻⁷ millibar) or ultra-high vacuum (e.g., below 10⁻⁷ millibar). Establishing and maintaining such vacuum conditions may involve the use of vacuum pumps, valves, sealing elements, and the like integrated into or connected to the ion mill 1000.

A material that remains stable under vacuum conditions may refer to a substance that does not significantly outgas, sublimate, or degrade when exposed to the low-pressure environments of the ion mill 1000. Under vacuum conditions, the material must exhibit a vapor pressure below a predetermined threshold to avoid contamination of the vacuum chamber or interference with the etching process, thereby ensuring clean and consistent experimental results. Such materials may include at least one of silicone elastomers (e.g., low-outgassing room-temperature vulcanizing silicones), waxes with low vapor pressures (e.g., Apiezon W or N-type vacuum wax), epoxy resins designed for vacuum applications (e.g., Torr Seal), metals with low volatility (e.g., Wood's metal, indium), thermoplastics like polyimide (Kapton) or PTFE (polytetrafluorethylene), which may be chemically stable and exhibit low outgassing.

Such materials may be selected or treated according to vacuum standards such as NASA's outgassing requirements or ASTM E595, ensuring compatibility with high or ultra-high vacuum systems.

Fig. 4 depicts a schematic illustration of a further example of a device 400 according to the present disclosure. On the left, the device 400 is shown from the side, and on the right, the device 400 is shown from the top. The device or sample holder 400 includes an etching mask 420 and a sample holding structure 440. The device 400 is configured to clamp a sample 410 (as discussed under reference of Fig. 2b) between the sample holding structure 440 and the etching mask 420.

To do so, the sample holding structure 440 may include a first part 450 (e.g. sample carrier structure) configured to be in (direct) contact with the sample 410, and a second part 460 (e.g. mask carrier structure) configured for attachment of the etching mask 420. The etching mask 420 may be positioned on the second part 460. A desired angle for slope etching may be adjusted for the mask 420 to be brought in contact with the sample. The etching mask 420 may be part of the second part 460 or may be distinct from the second part 460.

The first part 450 and the second part 460 may be connected based on a construction including a deformable element 430. The deformable element 430 may be provided between the first part 450 and the second part 460. The deformable element 430 may be or may include any member that, when deformed, generates a force that pulls the first part 450 and the part portion 460 toward each other so as to generate a clamping force that clamps the sample between the first part 450 and the second part 460 (or, in this example, between the first part 450 and the mask 420 on the second part 460).

For example, the deformable element 430 may be based on at least one spring. When the first part 450 and the second part 460 are pulled apart, a spring force may increase that is directed into the opposite direction than the pulling direction. Thereby, when the sample 410 is placed in between the first part 450 and the mask, the spring force may correspond to the clamping force that holds the sample.

The clamping force may be further increased, for example, based on at least one fixing member, such as a screw 470 that may be screwed to put more tension on the spring or to tighten the first part 450 directly with the second part 460. In the latter case, the spring 430 may be provided around a channel 480 that connects the first part 450 with the second part 460 and that includes a thread for the screw 470. In such an example, the spring 430 may serve as a first clamping mechanism to provide an initial positioning of the sample 410, and the screw 470 with the channel 480 may serve as a second clamping mechanism to fix the sample between the first part 450 and the mask 420. The screw may further be used to adjust a distance between the first part 450 and the second part 460 to accommodate for different thicknesses of samples and/or for different pressures that shall be exerted to different samples.

In some examples, multiple (at least two) fixing members may be provided (and in some examples, a corresponding number of springs), for example on a same horizontal line. For example, in the case of two screws provided on a left side and a right side of the front of the second part 460, the two screws can be adjusted individually to accommodate for a tilted surface of the sample 410.

According to the example of Fig. 4, further technical effects may be achieved. For example, a pressure exerted to the sample may be adjusted precisely, such that sample quality may be preserved and the sample 410 is ideally not damaged. On the other hand, the pressure can be adjusted to be not too low, such that no gaps or only small gaps may be present between the mask 420 and the sample 410. Also, time needed for positioning the sample may be decreased. Moreover, the example of Fig. 4 provides a technique where the sample can be positioned upright (in contrast to a sample that is laying on the sample stage), such that development of too much heat can be avoided.

More details and aspects are mentioned in connection with the examples described above or below. The example of Fig. 4 may comprise one or more optional additional features corresponding to one or more aspects mentioned in connection with the proposed concept or one or more examples described above (e.g. Fig. 1a-3b) or below (e.g. Fig. 5).

Fig. 5 shows a schematic illustration of a sample holder 500 according to an example. The deformable element structure comprises the deformable element 530 and an etch mask carrier structure 524. The deformable element 530 may be arranged (e.g. sandwiched) between the etching mask 522 and the etch mask carrier structure 524. The deformable element 530 may be deformable to enable a movement (e.g tilting) of the etching mask 522 relative to the etch mask carrier structure 524. The etch mask carrier structure 524 may be moveable connected to the sample carrier structure 450. For example, etch mask carrier structure 524 may be moveable orthogonal to the carrier surface of the sample carrier structure 450. The deformable element 5 may have a laminar geometry.

More details and aspects are mentioned in connection with the examples described above or below. The example of Fig. 5 may comprise one or more optional additional features corresponding to one or more aspects mentioned in connection with the proposed concept or one or more examples described above (e.g. Fig. 1a-4) or below.

Some examples relate to a method for etching a sample with an ion mill. The method may comprise pressing a sample directly or indirectly towards a carrier surface at an edge of an etching mask during etching by a deformable element structure. The sample is placed on the carrier surface of a sample carrier structure. The etching mask is configured to shield a portion of the sample with respect to an ion beam of the ion mill. The deformable element structure is a deformable element or comprises a deformable element.

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor or other programmable hardware component. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

**1.** A sample holder (300; 305; 400; 500) for holding a sample (310; 410; 510) during etching with an ion mill (1000), the sample holder (300; 400; 500) comprising:
a sample carrier structure (450) comprising a carrier surface for the placement of a sample (310; 410; 510);
an etching mask (320; 420; 522) configured to shield a portion of the sample (310; 410; 510) with respect to an ion beam (1010) of an ion mill (1000) during etching; and
a deformable element structure configured to press the sample directly or indirectly towards the carrier surface at an edge of the etching mask during etching, wherein the deformable element structure is a deformable element (330; 335; 430; 530) or comprises a deformable element (330; 335; 430; 530).

**2.** The sample holder of claim 1, wherein the deformable element (430; 530) is arranged in the force flow between the etching mask (420; 520; 522) and the sample carrier structure (450).

**3.** The sample holder of claim 1 or 2, wherein the deformable element structure comprises the deformable element (530) and an etch mask carrier structure (524), wherein the deformable element (530) is arranged between the etching mask (522) and the etch mask carrier structure (524), wherein the deformable element (530) is deformable to enable a movement of the etching mask (522) relative to the etch mask carrier structure (524).

**4.** The sample holder of claim 1 or 2, wherein the deformable element (430) is a tension spring configured to pull the etching mask towards the carrier surface of the sample carrier structure (450).

**5.** The sample holder of claim 1 or 2, wherein the deformable element (430) is a compression spring configured to push a mask carrier structure of the deformable element structure towards a screw head of a screw (470) of the deformable element structure, wherein the etching mask (420) is connected to the mask carrier structure, wherein the screw is configured to adjust a distance between the etching mask (420) and the carrier surface of the sample carrier structure (450).

**7.** The sample holder of one of the previous claims, wherein the sample holder is configured to change an orientation of the edge of the etching mask (420; 522) due to an elastic deformation of the deformable element (430; 530).

**8.** The sample holder of claim 1, wherein the deformable element (330; 335) is attached to the edge of the etching mask (320).

**9.** The sample holder of claim 8, wherein the deformable element (330; 335) is configured to fill a gap between the etching mask (320) and the sample (310).

**10.** The sample holder of claim 8 or 9, wherein the deformable element (330; 335) is configured to adapt to a surface contour of the sample by plastic or elastic deformation of the deformable element (330; 335).

**11.** The sample holder of one of the previous claims, wherein the etching mask (320; 420; 522) comprises a bottom surface extending from the edge of the etching mask (320; 420; 522) and facing the carrier surface of the sample carrier structure (450), wherein the bottom surface of the etching mask (320; 420; 522) and the carrier surface of the sample carrier structure (450) are non-parallel.

**12.** The sample holder of one of the previous claims, wherein the edge of the etching mask (320; 420; 522) is in parallel to the carrier surface of the sample carrier structure (450), if no sample is placed in the sample holder.

**13.** The sample holder of one of the previous claims, wherein the deformable element (330; 335; 430; 530) is a spring or comprises at least one of silicone, a wax, a Wood's metal, a resin, or a cellulose acetate.

**14.** The sample holder of one of the previous claims, wherein the etching mask (320; 420; 522) comprises at least one of chromium or nickel.

**15.** An ion mill (1000) comprising a sample holder according to any one of claims 1 to 14.
